# EUROPEAN PATENT APPLICATION

(11) **EP 2 600 409 A1**
(43) Date of publication of application: **05.06.2013**
(21) Application number: 11812145.8
(22) Date of filing: 17.05.2011
(51) Int. Cl.: H01L 31/04

(54) **METHOD FOR PRODUCTION OF PHOTOELECTRIC CONVERSION DEVICE**

(30) Priority: 28.07.2010 JP 2010169231
(71) Applicant: Mitsubishi Heavy Industries, Ltd., Tokyo 108-8215 (JP)
(72) Inventor: AKIHO, Yuhei, Tokyo 108-8215 (JP); YAMANE, Tsukasa, Tokyo 108-8215 (JP); NISHIMIYA, Tatsuyuki, Tokyo 108-8215 (JP)
(74) Representative: Bongiovanni, Simone
(86) International application number: PCT/JP2011/061318
(87) International publication number: WO 2012/014550

(57) **Abstract**

A production process that enables the output of a photovoltaic device to be improved via a simple treatment step. Specifically, a process for producing a photovoltaic device (100), the process comprising the steps of forming a first power generation cell layer (91) on a substrate (1), forming an intermediate contact layer (5) on the first power generation cell layer (91), and forming a second power generation cell layer (92) on the intermediate contact layer (5), wherein the process comprises at least one of a step of holding the substrate (1) in an open atmosphere at room temperature for 5 to 25 hours inclusive following formation of the first power generation cell layer (91), and a step of holding the substrate (1) in an open atmosphere at room temperature for 20 to 50 hours inclusive following formation of the intermediate contact layer (5).

## Description

### {Technical Field}

The present invention relates to a photovoltaic device, and relates particularly to a thin-film solar cell in which the power generation layer is formed by deposition.

### {Background Art}

One known example of a photovoltaic device that converts the energy from sunlight into electrical energy is a thin-film silicon-based solar cell comprising a photovoltaic layer composed of a p-type silicon-based semiconductor (p-layer), an i-type silicon-based semiconductor (i-layer) and an n-type silicon-based semiconductor (n-layer). Advantages of thin-film silicon-based solar cells include the comparative ease with which the surface area can be increased, and the fact that the film thickness is approximately 1/100th that of a crystalline solar cell, meaning minimal material is required. As a result, thin-film silicon-based solar cells can be produced at lower cost than crystalline solar cells.

In this technical field, improving the conversion efficiency is a very important task, and tandem solar cells have been proposed that have a photovoltaic layer prepared by stacking a power generation cell layer composed of amorphous silicon and a power generation cell layer composed of crystalline silicon stacked in that order on a substrate. In tandem solar cells, an intermediate contact layer composed of a transparent conductive film is inserted between the amorphous silicon layers and the crystalline silicon layers for the purposes of inhibiting the mutual diffusion of dopants between the layers and adjusting the light intensity distribution. One layer of a transparent conductive film of Ga-doped ZnO (GZO) or Al-doped ZnO (AZO) or the like is generally provided as the intermediate contact layer.

Generally, the photovoltaic layer is formed by a plasma-enhanced CVD method, and the intermediate contact layer is formed by a sputtering method. Consequently, in the period between formation of one power generation cell layer and the formation of the intermediate contact layer, the deposited layer is temporarily moved form a vacuum atmosphere and exposed to the open atmosphere. As a result, a silicon-based oxide film or impurities layer is formed on the surface of the power generation cell layer. It is thought that this causes a deterioration in the performance of the photovoltaic device.

Various measures have been adopted to prevent this type of deterioration in the performance of the photovoltaic device.
For example, Patent Literature (PTL) 1 discloses a process for producing a tandem solar cell which comprises: forming a first photovoltaic unit (power generation cell layer) on a substrate, subsequently performing a hydrogen plasma treatment to remove an oxide film and any foreign matter formed on the outermost surface of the first photovoltaic unit as a result of exposure to the atmosphere, and then forming a second photovoltaic unit.
PTL 2 discloses a method of avoiding the effects of contamination by forming an intermediate reflective layer and the photovoltaic unit in a continuous manner by employing a conductive amorphous oxygenated silicon as the intermediate reflective layer.

### {Citation List}

### {Patent Literature}

{PTL 1} Japanese Unexamined Patent Application, Publication No. 2002-237608 (claim 1, and paragraphs [0018] and [0022])
{PTL 2} Japanese Unexamined Patent Application, Publication No. 2005-135987 (claim 1, and paragraphs [0055] and [0075])

### {Summary of Invention}

### {Technical Problem}

If consideration is given to adjustment of the takt time and maintenance period for each of the various processing steps on the production line, and the conducting of intermediate quality checks between each of the various processing steps, then the first power generation cell layer, the intermediate contact layer and the second power generation cell layer are preferably deposited within individual apparatus, rather than being formed by continuous deposition such as that described in PTL 2.
Further, the process of PTL 1 requires a hydrogen plasma treatment, but because management of the plasma treatment conditions and the production process is complex, production costs tend to increase.

The present invention has an object of providing a production process that enables the output of a photovoltaic device to be improved via a simple treatment step.

### {Solution to Problem}

In order to achieve the above object, the present invention provides a process for producing a photovoltaic device, the process comprising the steps of forming a first power generation cell layer on a substrate, forming an intermediate contact layer on the first power generation cell layer, and forming a second power generation cell layer on the intermediate contact layer, wherein the process comprises at least one of a step of holding the substrate in an open atmosphere at room temperature for not less than 5 hours and not more than 25 hours following formation of the first power generation cell layer, and a step of holding the substrate in an open atmosphere at room temperature for not less than 20 hours and not more than 50 hours following formation of the intermediate contact layer.

By controlling, within the time range described above, the time for which the substrate is held in an open atmosphere under the above conditions following formation of the first power generation cell layer, the output of the photovoltaic device can be improved effectively. If this holding time is less than 5 hours, then a stable output improvement effect cannot be obtained. On the other hand, even if the holding time is extended beyond 25 hours, no further improvement in performance is achieved, and the production efficiency deteriorates undesirably.
Further, as a result of intensive research, the inventors of the present invention discovered that the formation of an impurities layer on the surface of the intermediate contact layer is also a cause of a reduction in the performance of the photovoltaic device. Accordingly, the output of the photovoltaic device can also be improved effectively by controlling, within the time range described above, the time for which the substrate is held in an open atmosphere under the above conditions following formation of the intermediate contact layer. If this holding time is less than 20 hours, then a stable output improvement effect cannot be obtained. On the other hand, even if the holding time is extended beyond 50 hours, no further performance improvement effect is obtained, and the time required for production simply lengthens.
In the present invention, the holding step following formation of the first power generation cell layer and the holding step following formation of the intermediate contact layer may be implemented in combination.

In one aspect of the present invention, the process preferably comprises at least one of a step of holding the substrate in an open atmosphere at room temperature for not less than 8 hours and not more than 20 hours following formation of the first power generation cell layer, and a step of holding the substrate in an open atmosphere at room temperature for not less than 40 hours and not more than 50 hours following formation of the intermediate contact layer.

By controlling, within the respective time ranges described above, at least one of the time for which the substrate is held in an open atmosphere under the above conditions following formation of the first power generation cell layer, and the time for which the substrate is held in an open atmosphere under the above conditions following formation of the intermediate contact layer, the output of the photovoltaic device can be improved more reliably.

Further, in another aspect of the present invention, the substrate is preferably held inside a clean stocker of class 100,000 or less.

By specifying the environment in which the substrate is held as the inside of a clean stocker of class 100,000 or less, foreign matter does not adhere to the surfaces of the films deposited on the substrate, even during the long substrate holding state, and therefore the output of the photovoltaic device can be improved even more reliably.

### {Advantageous Effects of Invention}

In this manner, the output of the photovoltaic device can be improved by controlling the holding step performed following formation of the first power generation cell layer and/or the holding step performed following formation of the intermediate contact layer. The present invention is able to achieve an improvement in the performance of the photovoltaic device using a simple treatment step, and therefore also has the effect of simplifying takt time adjustment and the like.

### {Brief Description of Drawings}

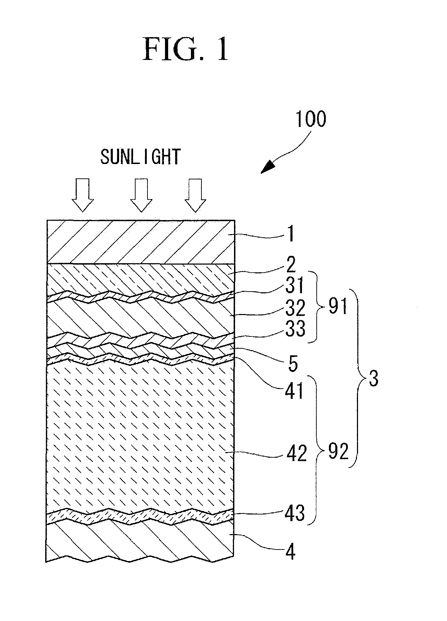

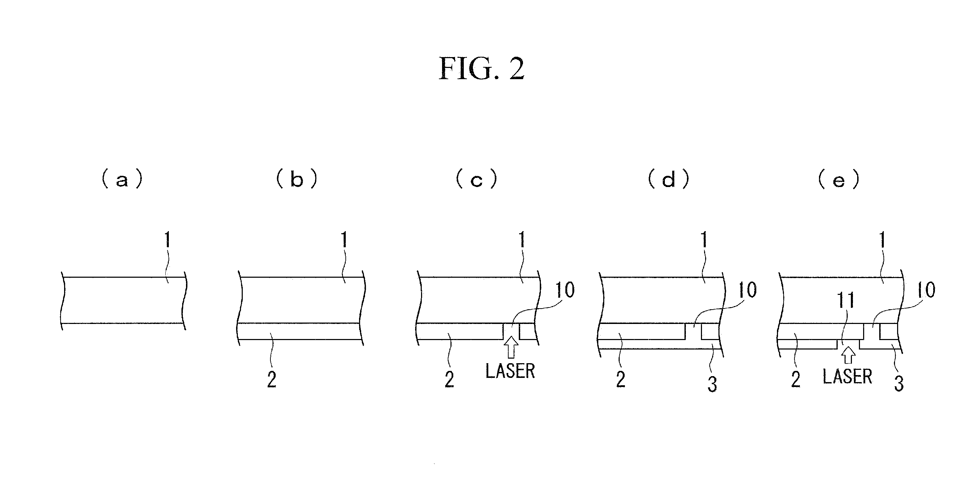

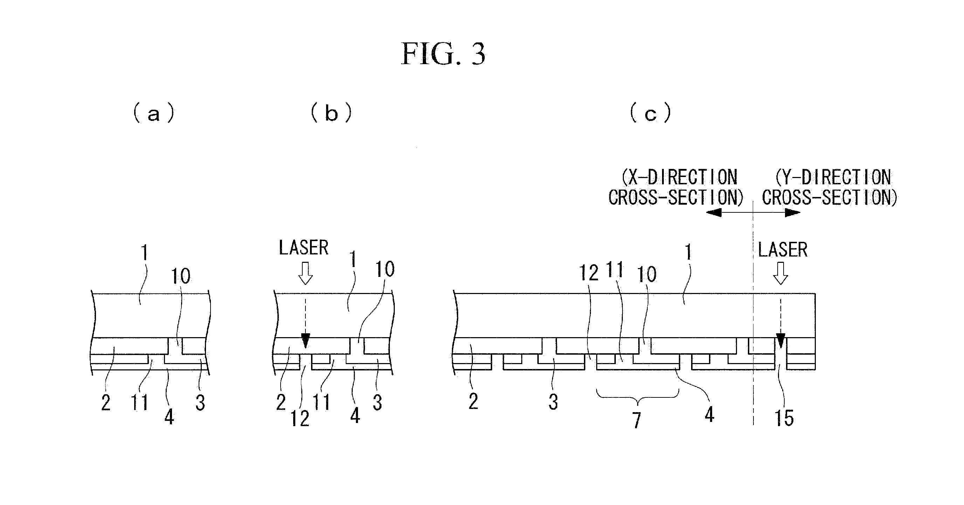

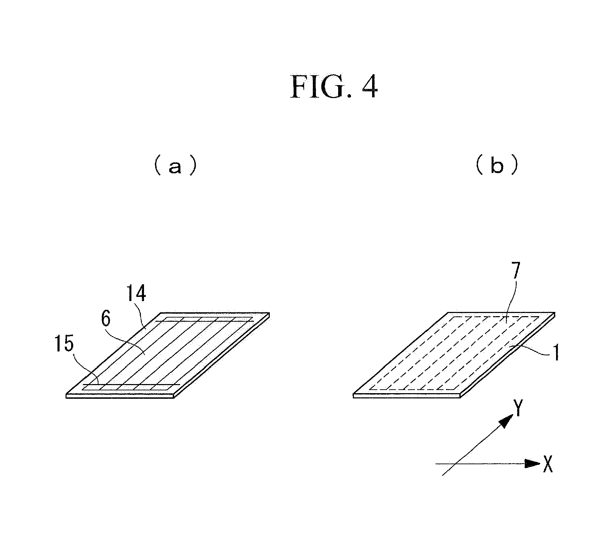

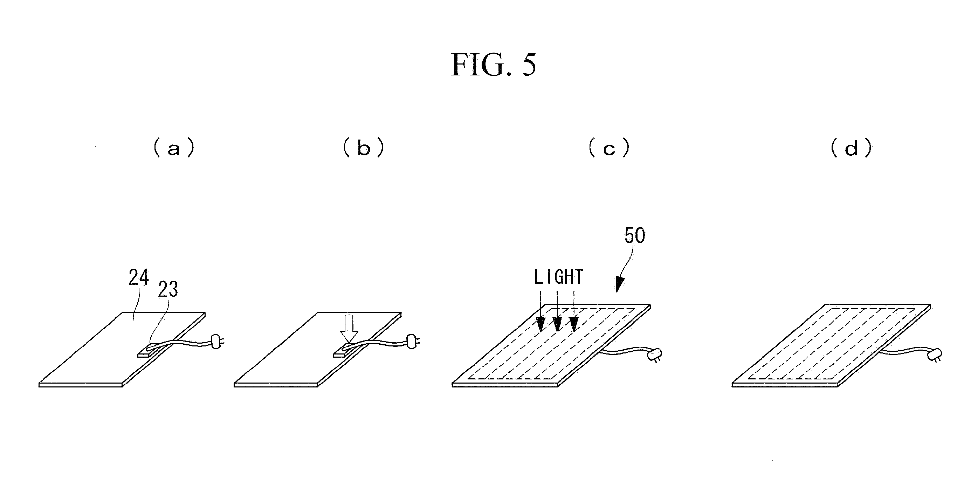

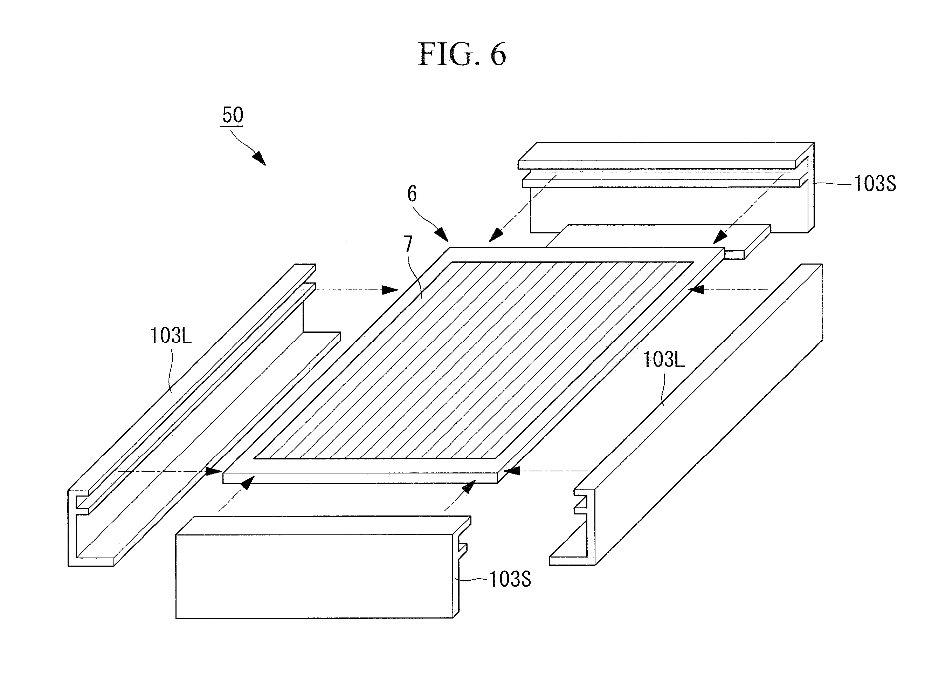

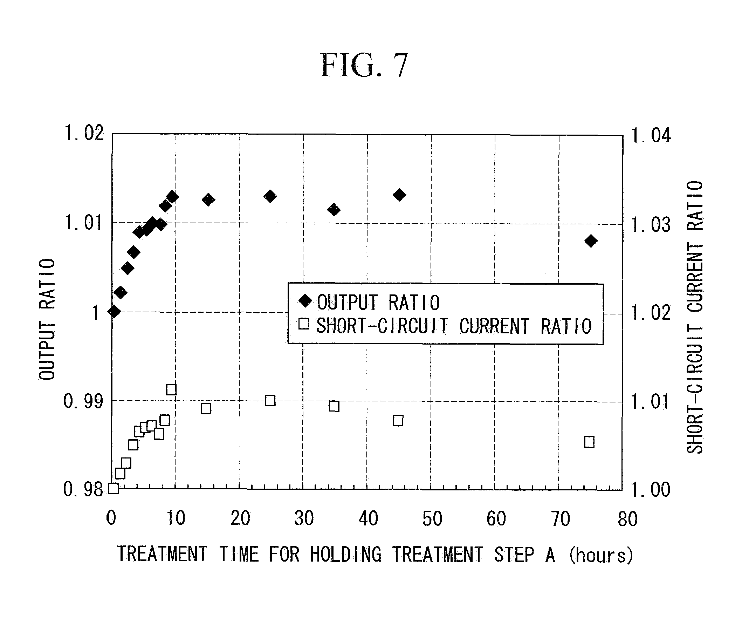

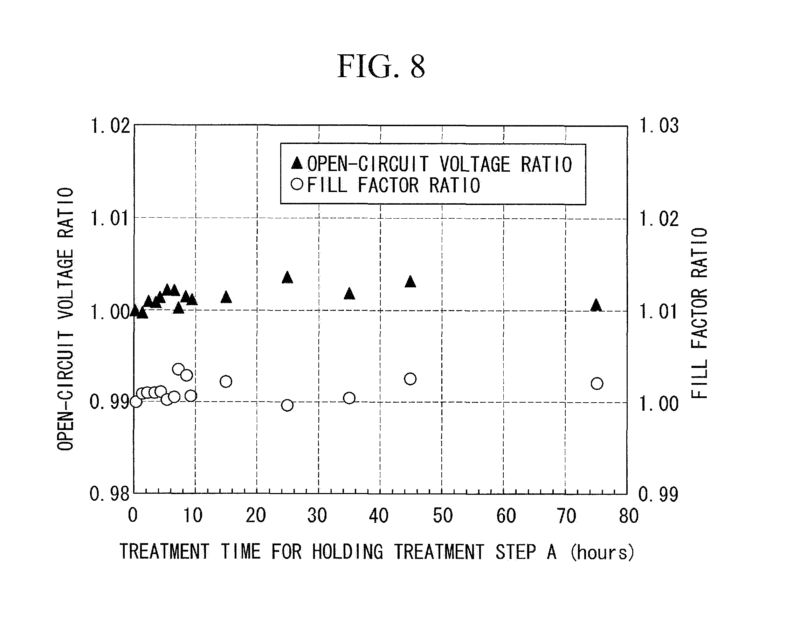

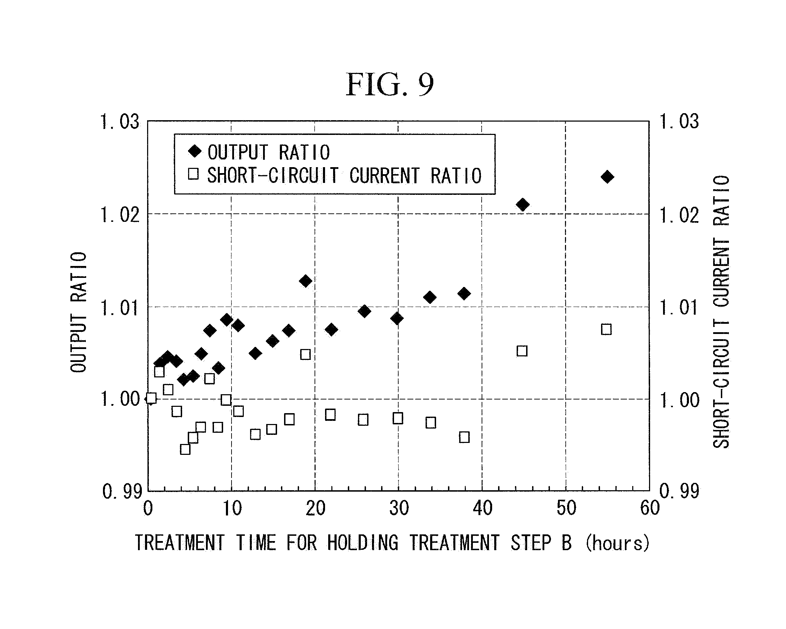

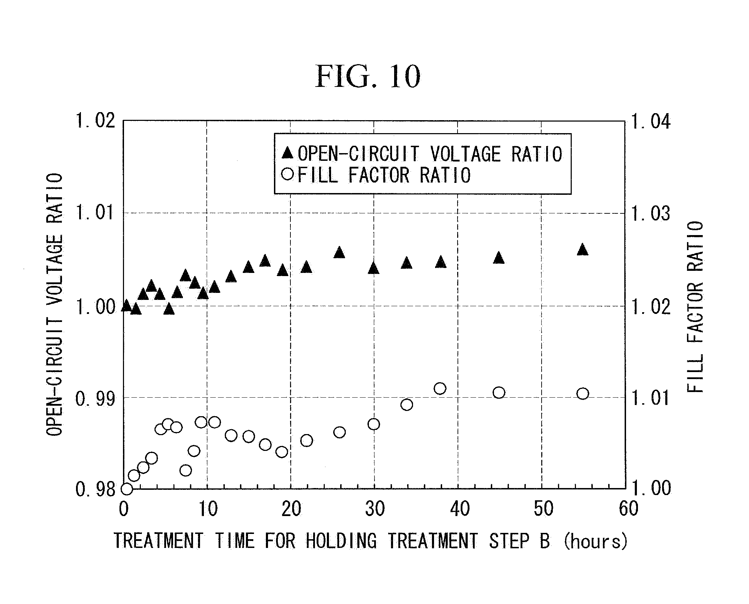

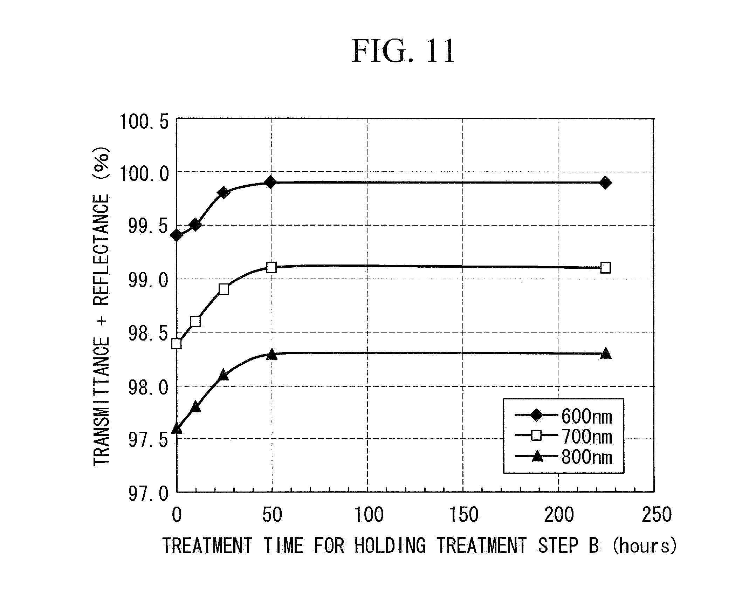

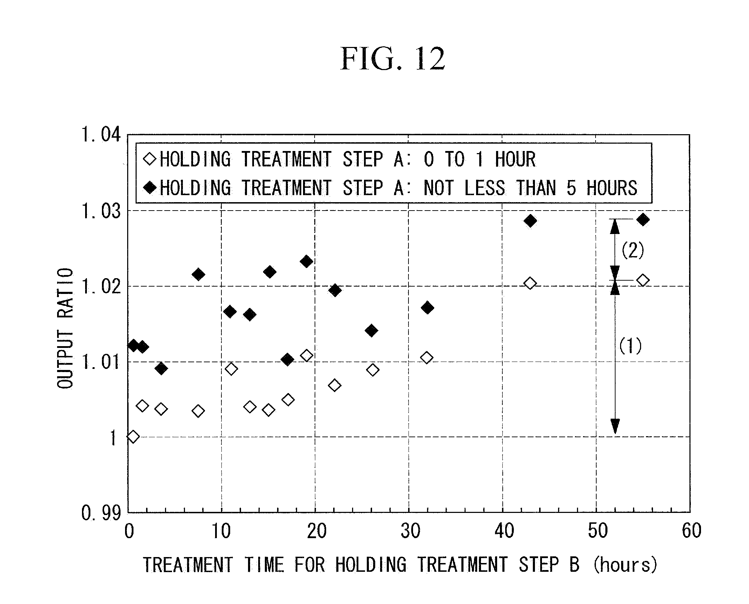

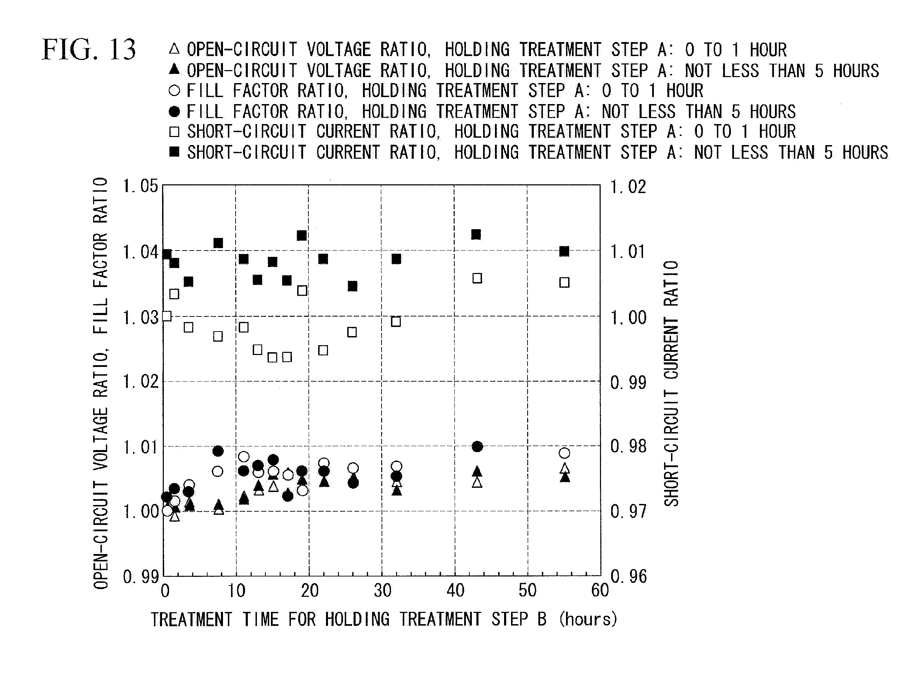

{Fig. 1} A schematic view illustrating the structure of a photovoltaic device produced using a process for producing a photovoltaic device according to the present invention.
{Fig. 2} A schematic illustration describing one embodiment for producing a solar cell panel using a process for producing a photovoltaic device according to the present invention.
{Fig. 3} A schematic illustration describing one embodiment for producing a solar cell panel using a process for producing a photovoltaic device according to the present invention.
{Fig. 4} A schematic illustration describing one embodiment for producing a solar cell panel using a process for producing a photovoltaic device according to the present invention.
{Fig. 5} A schematic illustration describing one embodiment for producing a solar cell panel using a process for producing a photovoltaic device according to the present invention.
{Fig. 6} A schematic illustration describing one embodiment for producing a solar cell panel using a process for producing a photovoltaic device according to the present invention.
{Fig. 7} A graph illustrating the relationship between the treatment time for a holding treatment step A, and the output and short-circuit current of a produced solar cell module.
{Fig. 8} A graph illustrating the relationship between the treatment time for the holding treatment step A, and the open-circuit voltage and fill factor of a produced solar cell module.
{Fig. 9} A graph illustrating the relationship between the treatment time for a holding treatment step B, and the output and short-circuit current of a produced solar cell module.
{Fig. 10} A graph illustrating the relationship between the treatment time for the holding treatment step B, and the open-circuit voltage and fill factor of a produced solar cell module.
{Fig. 11} A graph illustrating the effects that the time of the holding treatment step has on the optical properties of the intermediate contact layer.
{Fig. 12} A graph illustrating, for those cases where both the holding treatment step A and the holding treatment step B are implemented, the relationship between the treatment time for the holding treatment step B, and the output of a produced solar cell module.
{Fig. 13} A graph illustrating, for those cases where both the holding treatment step A and the holding treatment step B are implemented, the relationship between the treatment time for the holding treatment step B, and the open-circuit voltage, the fill factor and the short-circuit current of a produced solar cell module.

### {Description of Embodiments}

Fig. 1 is a schematic view illustrating the structure of a photovoltaic device according to the present invention. A photovoltaic device 100 is a tandem silicon-based solar cell, and comprises a substrate 1, a transparent electrode layer 2, a solar cell photovoltaic layer 3 comprising a first power generation cell layer 91 (amorphous silicon-based) and a second power generation cell layer 92 (crystalline silicon-based), an intermediate contact layer 5, and a back electrode layer 4. Here, the term "silicon-based" is a generic term that includes silicon (Si), silicon carbide (SiC) and silicon germanium (SiGe). Further, the term "crystalline silicon-based" describes a silicon system other than an amorphous silicon system, and includes both microcrystalline silicon systems and polycrystalline silicon systems.

A process for producing a photovoltaic device according to one embodiment of the present embodiment is described below, using the steps for producing a solar cell panel as an example. Fig. 2 to Fig. 5 are schematic views illustrating the process for producing a solar cell panel according to this embodiment.

### (1) Fig. 2(a)

large soda float glass substrate with a surface area exceeding 1 m² (for example, with dimensions of 1.4 m × 1.1 m × thickness: 3.0 to 4.5 mm) is used as the substrate 1. The edges of the substrate are preferably subjected to corner chamfering or R-face chamfering to prevent damage caused by thermal stress or impacts or the like.

### (2) Fig. 2(b)

A transparent conductive film comprising mainly tin oxide (SnO₂) and having a film thickness of approximately not less than 500 nm and not more than 900 nm is deposited as the transparent electrode layer 2, using a thermal CVD apparatus at a temperature of approximately 500°C. During this deposition, a texture having suitable asperity is formed on the surface of the transparent conductive film. In addition to the transparent conductive film, the transparent electrode layer 2 may also include an alkali barrier film (not shown in the figure) formed between the substrate 1 and the transparent conductive film. The alkali barrier film is formed using a thermal CVD apparatus at a temperature of approximately 500°C to deposit a silicon oxide film (SiO₂) having a film thickness of 20 nm to 50 nm.

### (3) Fig. 2 (c)

Subsequently, the substrate 1 is mounted on an X-Y table, and the first harmonic of a YAG laser (1064 nm) is irradiated onto the surface of the transparent electrode layer, as shown by the arrow in the figure. The laser power is adjusted to ensure an appropriate process speed, and the transparent electrode layer is then moved in a direction perpendicular to the direction of the series connection of the power generation cells, thereby causing a relative movement between the substrate 1 and the laser light, and conducting laser etching across a strip having a predetermined width of approximately 6 mm to 15 mm to form a slot 10.

### (4) Fig. 2(d)

Using a plasma-enhanced CVD apparatus, a p-layer, an i-layer and an n-layer, each composed of a thin film of amorphous silicon, are deposited as the first power generation cell layer 91. Using SiH₄ gas and H₂ gas as the main raw materials, and under conditions including a reduced-pressure atmosphere of not less than 30 Pa and not more than 1,000 Pa and a substrate temperature of approximately 200°C, an amorphous silicon p-layer 31, an amorphous silicon i-layer 32 and an amorphous silicon n-layer 33 are deposited, in that order, on the transparent electrode layer 2, with the p-layer closest to the surface from which incident sunlight enters. The amorphous silicon p-layer 31 comprises mainly amorphous B-doped silicon, and has a thickness of not less than 10 nm and not more than 30 nm. The amorphous silicon i-layer 32 has a thickness of not less than 200 nm and not more than 350 nm. The amorphous silicon n-layer 33 comprises mainly P-doped silicon in which microcrystalline silicon is incorporated within amorphous silicon, and has a thickness of not less than 30 nm and not more than 50 nm. A buffer layer may be provided between the amorphous silicon p-layer 31 and the amorphous silicon i-layer 32 in order to improve the interface properties.

Following formation of the first power generation cell layer 91, the substrate is transported out from the plasma-enhanced CVD apparatus. During the period from deposition of the first power generation cell layer 91 until deposition of the intermediate contact layer 5, the substrate with the first power generation cell layer formed thereon is held in an open atmosphere at room temperature (20 to 28°C) (holding treatment step A). The treatment time is not less than 5 hours and not more than 25 hours, and is preferably not less than 8 hours and not more than 20 hours. In this step, the treatment time is defined as the time from immediately after deposition of the first power generation cell layer 91 until the start of deposition of the intermediate contact layer 5.
During the holding of the substrate, the substrate is stored, for example, inside a stocker in a clean room (of approximately class 10,000 to class 100,000), in order to prevent foreign matter adhering to the outermost surface of the first power generation cell layer.
The terms "class 10,000" and "class 100,000" indicate that the number of particles of 0.3 µm or greater within 1 ft³ of space is not more than 10,000 or not more than 100,000 respectively. Further, the entire production facility need not be a clean room, provided that the space through which the substrate is transported, and the inside of the stocker where the substrate is held are either class 10,000 or not more than class 100,000.

An intermediate contact layer 5 that functions as a semi-reflective film for improving the contact properties and achieving electrical current consistency is provided on the first power generation cell layer 91. For the intermediate contact layer 5, a Ga-doped or Al-doped ZnO film having a thickness of not less than 20 nm and not more than 100 nm is deposited using a sputtering apparatus with a Ga-doped ZnO sintered body or an Al-doped ZnO sintered body as the target.

Following formation of the intermediate contact layer 5, the substrate is transported out from the sputtering apparatus. During the period from deposition of the intermediate contact layer 5 until deposition of the second power generation cell layer 92, the substrate is held in an open atmosphere at room temperature (holding treatment step B). The treatment time is not less than 20 hours and not more than 50 hours, and is preferably not less than 40 hours and not more than 50 hours. In this step, the treatment time is defined as the time from immediately after deposition of the intermediate contact layer 5 until the start of deposition of the second power generation cell layer 92.
In this step, in a similar manner to that described above, the substrate is preferably stored inside a stocker in a clean room in order to prevent foreign matter adhering to the outermost surface of the intermediate contact layer.

In the present embodiment, either only one of the holding treatment step A or holding treatment step B may be implemented, or both steps may be implemented.

Next, using a plasma-enhanced CVD apparatus, and under conditions including a reduced-pressure atmosphere of not more than 3,000 Pa, a substrate temperature of approximately 200°C and a plasma generation frequency of not less than 40 MHz and not more than 100 MHz, a crystalline silicon p-layer 41, a crystalline silicon i-layer 42 and a crystalline silicon n-layer 43 are deposited sequentially as the second power generation cell layer 92 on top of the intermediate contact layer 5. The crystalline silicon p-layer 41 comprises mainly B-doped microcrystalline silicon, and has a thickness of not less than 10 nm and not more than 50 nm. The crystalline silicon i-layer 42 comprises mainly microcrystalline silicon, and has a thickness of not less than 1.2 µm and not more than 3.0 µm. The crystalline silicon n-layer 43 comprises mainly P-doped microcrystalline silicon, and has a thickness of not less than 20 nm and not more than 50 nm. The crystalline silicon n-layer may be substituted with an amorphous silicon n-layer.

During formation of the i-layer comprising mainly microcrystalline silicon using a plasma-enhanced CVD method, a distance d between the plasma discharge electrode and the surface of the substrate 1 is preferably not less than 3 mm and not more than 10 mm. If this distance d is less than 3 mm, then the precision of the various structural components within the film deposition chamber required for processing large substrates means that maintaining the distance d at a constant value becomes difficult, which increases the possibility of the electrode getting too close and making the discharge unstable. If the distance d exceeds 10 mm, then achieving a satisfactory deposition rate (of at least 1 nm/s) becomes difficult, and the uniformity of the plasma also deteriorates, causing a deterioration in the quality of the film due to ion impact.

### (5) Fig. 2 (e)

The substrate 1 is mounted on an X-Y table, and the second harmonic of a laser diode-excited YAG laser (532 nm) is irradiated onto the surface of the photovoltaic layer 3, as shown by the arrow in the figure. With the pulse oscillation set to 10 kHz to 20 kHz, the laser power is adjusted so as to achieve a suitable process speed, and laser etching is conducted at a point approximately 100 µm to 150 µm to the side of the laser etching line within the transparent electrode layer 2, so as to form a slot 11. The laser may also be irradiated from the side of the substrate 1, and in this case, because the high vapor pressure generated by the energy absorbed by the first power generation cell layer 91 of the photovoltaic layer 3 can be utilized in etching the photovoltaic layer 3, more stable laser etching processing can be performed. The position of the laser etching line is determined with due consideration of positioning tolerances, so as not to overlap with the etching line formed in the preceding step.

### (6) Fig. 3(a)

Using a sputtering apparatus, an Ag film and a Ti film are deposited as the back electrode layer 4, under a reduced-pressure atmosphere and at a deposition temperature of 150°C to 200°C. In this embodiment, an Ag film having a thickness of not less than 150 nm and not more than 500 nm, and a highly corrosion-resistant Ti film having a thickness of not less than 10 nm and not more than 20 nm which acts as a protective film for the Ag film are stacked in that order. Alternatively, the back electrode layer 4 may be formed as a stacked structure composed of an Ag film having a thickness of 25 nm to 100 nm, and an Al film having a thickness of 15 nm to 500 nm. Further, in the case of a device that also requires long-wavelength reflected light of 600 nm or greater, such as a tandem solar cell, the back electrode layer 4 may be formed as a stacked structure composed of a Cu film having a thickness of approximately 100 nm to 450 nm, and a Ti film having a thickness of approximately 5 nm to 150 nm.
In order to reduce the contact resistance between the n-layer 43 and the back electrode layer 4 and improve the reflectance, a sputtering apparatus may be used to deposit a Ga-doped or Al-doped ZnO film with a thickness of not less than 50 nm and not more than 100 nm between the photovoltaic layer 3 and the back electrode layer 4.

### (7) Fig. 3 (b)

The substrate 1 is mounted on an X-Y table, and the second harmonic of a laser diode-excited YAG laser (532 nm) is irradiated through the substrate 1, as shown by the arrow in the figure. The laser light is absorbed by the photovoltaic layer 3, and by utilizing the high gas vapor pressure generated at this point, the back electrode layer 4 is removed by explosive fracture. With the pulse oscillation set to not less than 1 kHz and not more than 50 kHz, the laser power is adjusted so as to achieve a suitable process speed, and laser etching is conducted at a point approximately 250 µm to 400 µm to the side of the laser etching line within the transparent electrode layer 2, so as to form a slot 12.

### (8) Fig. 3(c) and Fig. 4(a)

The electric power generation region is then compartmentalized, by using laser etching to remove the effect wherein the serially connected portions at the film edges near the edges of the substrate are prone to short circuits. The substrate 1 is mounted on an X-Y table, and the second harmonic of a laser diode-excited YAG laser (532 nm) is irradiated through the substrate 1. The laser light is absorbed by the transparent electrode layer 2 and the photovoltaic layer 3, and by utilizing the high gas vapor pressure generated at this point, the back electrode layer 4 is removed by explosive fracture, and the back electrode layer 4, the photovoltaic layer 3 and the transparent electrode layer 2 are removed. With the pulse oscillation set to not less than 1 kHz and not more than 50 kHz, the laser power is adjusted so as to achieve a suitable process speed, and laser etching is conducted at a point approximately 5 mm to 20 mm from the edge of the substrate 1, so as to form an X-direction insulation slot 15 as illustrated in Fig. 3(c). Fig. 3(c) represents an X-direction cross-sectional view cut along the direction of the series connection of the photovoltaic layer 3, and therefore the location in the figure where the insulation slot 15 is formed should actually appear as a peripheral film removed region 14 in which the back electrode layer 4, the photovoltaic layer 3 and the transparent electrode layer 2 have been removed by film polishing (see Fig. 4(a)), but in order to facilitate description of the processing of the edges of the substrate 1, this location in the figure represents a Y-direction cross-sectional view, so that the formed insulation slot represents an X-direction insulation slot 15. A Y-direction insulation slot need not be provided at this point, because a film surface polishing and removal treatment is conducted on the peripheral film removal regions of the substrate 1 in a later step.

Completing the etching of the insulation slot 15 at a position 5 mm to 15 mm from the edge of the substrate 1 is preferred, as it ensures that the insulation slot 15 is effective in inhibiting external moisture from entering the interior of the solar cell module 6 via the edges of the solar cell panel.

Although the laser light used in the steps until this point has been specified as YAG laser light, light from a YV04 laser or fiber laser or the like may also be used in a similar manner.

### (9) Fig. 4 (a: view from solar cell film surface side, b: view from substrate side of light incident surface)

In order to ensure favorable adhesion and sealing of a backing sheet 24 via EVA or the like in a subsequent step, the stacked films around the periphery of the substrate 1 (in a peripheral film removal region 14), which tend to be uneven and prone to peeling, are removed to form a peripheral film removed region 14. During removal of the films from a region that is 5 to 20 mm from the edge around the entire periphery of the substrate 1, grinding or blast polishing or the like is used to remove the back electrode layer 4, the photovoltaic layer 3 and the transparent electrode layer 2 from a region that is closer to the substrate edge in the X direction than the insulation slot 15 provided in the above step of Fig. 3(c), and closer to the substrate edge in the Y direction than the slot 10 provided near the substrate edge.
Grinding debris or abrasive grains are removed by washing the substrate 1.

### (10) Fig. 5(a) (b)

Processing is conducted so as to enable current collection, using a copper foil, from the back electrode layer 4 of the power generation cell 7 at one end of the plurality of series-connected power generation cells, and the back electrode layer 4 of the current collection cell connected to the power generation cell 7 at the other end, thereby enabling electric power to be extracted from a terminal box 23 provided on the rear surface of the solar cell panel. In order to prevent short circuits between the copper foil used for current collection and the various portions, an insulating sheet that is wider than the width of the copper foil is provided.
Following arrangement of the current-collecting copper foil and the like at predetermined positions, the entire solar cell module 6 is covered with a sheet of an adhesive filler material such as EVA (ethylene-vinyl acetate copolymer), which is arranged so as not to protrude beyond the substrate 1.
A backing sheet 24 with a superior waterproofing effect is then positioned on top of the adhesive filler sheet. In this embodiment, in order to achieve a superior waterproofing and moisture-proofing effect, the backing sheet 24 is formed as a three-layer structure comprising a PET sheet, an Al foil and a PET sheet.
An open through-window is provided within an attachment portion for the terminal box 23 on the backing sheet 24, and the current-collecting copper foil is extracted through this open through-window. A plurality of layers of an insulating material are provided between the backing sheet 24 and the back electrode layer 4 within this open through-window portion in order to prevent external moisture and the like entering the module.
The structure comprising the components up to and including the backing sheet 24 arranged in predetermined positions is subjected to internal degassing under a reduced-pressure atmosphere and under pressing at approximately 150°C to 160°C using a laminator, thereby causing cross-linking of the adhesive filler sheet (EVA) that tightly seals the structure.
The adhesive filler sheet 25 is not limited to EVA, and an adhesive filler having similar functionality, such as PVB (polyvinyl butyral), may also be used. In such a case, the conditions employed such as the pressure bonding sequence, the temperature and the bonding time are optimized for the adhesive filler being used.

### (11) Fig. 5(a)

The terminal box 23 is attached to the back of the solar cell module 6 using an adhesive.

### (12) Fig. 5(b)

The copper foil and an output cable from the terminal box 23 are connected using solder or the like, and the interior of the terminal box 23 is filled and sealed with a sealant (a potting material). This completes the production of the solar cell panel 50. (13) Fig. 5(c)
The solar cell panel 50 formed via the steps up to and including Fig. 5(b) is then subjected to an electric power generation test, as well as other tests for evaluating specific performance factors. The electric power generation test is conducted using a solar simulator that emits a standard sunlight of AM 1.5 (1,000 W/m²). This electric power generation test may be performed following total completion of the solar cell panel 50, or may be performed prior to attachment of an aluminum frame to the module.

### (14) Fig. 5(d)

In tandem with the electric power generation test (Fig. 5(c)), a variety of specific performance factors including the external appearance are evaluated.

### (15) Fig. 6

An aluminum frame, which imparts strength to the solar cell module 6 and also functions as a mounting seat, is fitted around the periphery of the solar cell module 6. A rubber gasket or the like is preferably provided between the solar cell module 6 and the aluminum frames 103L and 103S, thereby reliably holding the module while maintaining elasticity.
This completes fabrication of the solar cell panel 50.

### (Example 1: Effects of Holding Treatment Step A)

A solar cell module having the stacked structure illustrated in Fig. 1 was formed on a glass substrate having dimensions of 1.4 m × 1.1 m. The thickness of each layer was as shown below.
Transparent electrode layer 2: 800 nm
First power generation cell layer 91: p-layer 10 to 20 nm, i-layer 200 nm, n-layer 30 to 40 nm
Intermediate contact layer (GZO film) 5: 50 to 90 nm, amount of Ga doping: 0.5% wt%
Second power generation cell layer 92: p-layer 20 to 30 nm, i-layer 1.5 to 1.8 µm, n-layer 30 to 40 nm
Back electrode layer (Ag film) 4: 250 nm

The deposition conditions for the i-layer of the first power generation cell layer 91 included a high-frequency power of 0.06 to 0.10 W/cm², a hydrogen dilution ratio (H₂ gas flow rate/SiH₄ gas flow rate) of 2-fold to 3-fold, and a deposition pressure of 150 to 250 Pa.
Following deposition of the first power generation cell layer, the holding treatment step A was performed at room temperature (average temperature: 22°C to 27°C), either inside a stocker in a clean room controlled at class 100,000 or less, or inside a clean stocker in which the interior of the stocker was controlled at class 100,000 or less, for a treatment time of 0 hours to 80 hours.
The deposition conditions for the intermediate contact layer 5 included a high-frequency power of 0.2 to 0.25 W/cm², an amount of introduced oxygen gas of 0.5 to 1 vol%, and a deposition pressure of 0.3 to 0.5 Pa.
The deposition conditions for the i-layer of the second power generation cell layer 92 included a high-frequency power of 1.0 to 1.5 W/cm², a hydrogen dilution ratio of 45-fold to 60-fold, and a deposition pressure of 1,500 to 2,500 Pa.

Fig. 7 illustrates the relationship between the treatment time for the holding treatment step A, and the output and short-circuit current of the produced solar cell module. In the figure, the horizontal axis represents the treatment time, the left vertical axis represents the output ratio, and the right vertical axis represents the short-circuit current ratio. Fig. 8 illustrates the relationship between the treatment time for the holding treatment step A, and the open-circuit voltage and fill factor of the produced solar cell module. In this figure, the horizontal axis represents the treatment time, the left vertical axis represents the open-circuit voltage ratio, and the right vertical axis represents the fill factor ratio. The output ratio, the short-circuit current ratio, the open-circuit voltage ratio and the fill factor ratio each represents a value that is normalized against the average value for the respective output ratio, short-circuit current ratio, open-circuit voltage ratio and fill factor value for a solar cell module produced using a treatment time of 0 to 1 hours.
In the plots illustrated in Fig. 7 and Fig. 8, the average value for each of the evaluation items was calculated in one-hour intervals for the period from a treatment time of 0 hours to a treatment time of 10 hours. For treatment times of 10 hours or longer, the average value for each of the evaluation items was calculated in ten-hour intervals.

As is evident from Fig. 7, for the period up to and including a treatment time of 5 hours, both the short-circuit current ratio and the output ratio showed an increasing trend. For treatment times of 5 hours or longer, the rate of increase in the short-circuit current ratio and the output ratio tended to reduce, and for treatment times of 10 hours or longer, there was substantially no change in the short-circuit current ratio and the output ratio. Reference to the results for treatment times of 10 hours to 50 hours confirms that the output increase effect has become saturated, with no further improvement observed even if the treatment time is lengthened. Further, the output ratio and the short-circuit current ratio showed a decreasing trend for treatment times of 70 to 80 hours. The average values observed for a treatment time of 20 to 30 hours represented an average increase of 1.5% in the output ratio and an average increase of 1.1% in the short-circuit current ratio.
Based on the above results, it can be stated that the treatment time must be not less than 5 hours. In order to achieve a more stable increased output, the treatment time is preferably 8 hours or longer. If consideration is also given to shortening the time required for completing production of the solar cell, and the volume of the stocker used for holding the substrate following deposition of the first power generation cell layer, then a shorter treatment time is preferable, and a treatment time of not more than 25 hours, and preferably not more than 20 hours, where a high output can be achieved with good stability, is ideal.

On the other hand, as is evident from Fig. 8, the open-circuit voltage ratio and the fill factor ratio underwent substantially no change for the tested treatment times.
Because the short-circuit current of the solar cell increases by implementing the holding treatment step A, it can be understood that the reflectance between the first power generation cell layer 91 (n-layer 33) and the intermediate contact layer 5 has improved, resulting in an increase in the current generated in the first power generation cell layer 91. It is surmised that, in the holding treatment step A, the atmospheric exposure following deposition causes the formation of an extremely thin film of a natural oxide of silicon on the surface of the n-layer 33 of the first power generation cell layer. If this natural oxide film is too thick, then the electrical resistance becomes overly large, which is undesirable. For a holding treatment time of 5 hours to 25 hours, as used in the present embodiment, a thin natural oxide film of approximately several nm is formed, and it is thought that the interposing of oxygen at the interface with the intermediate contact layer 5 acts effectively in improving the reflectance at the interface between the first power generation cell layer 91 and the intermediate contact layer 5.
In order to form an extremely thin, and not overly thick, film of a natural oxide of silicon on the surface of the n-layer 33 of the first power generation cell layer 91, a treatment step in which the substrate having the first power generation cell layer 91 formed thereon is held within an open atmosphere at room temperature for a prescribed period of time represents a reliable yet simple treatment method.

### (Example 2: Effects of Holding Treatment Step B)

A solar cell module having the stacked structure illustrated in Fig. 1 was formed on a glass substrate having dimensions of 1.4 m × 1.1 m.
The thickness and deposition conditions for each of the layers were the same as those described for the example 1. In the example 2, the holding treatment step A was not implemented, but following deposition of the intermediate contact layer, the holding treatment step B was performed at room temperature (average temperature: 22°C to 27°C), either inside a stocker in a clean room or inside a clean stocker, for a treatment time of 0 hours to 60 hours.

Fig. 9 illustrates the relationship between the treatment time for the holding treatment step B, and the output and short-circuit current of the produced solar cell module. In the figure, the horizontal axis represents the treatment time, the left vertical axis represents the output ratio, and the right vertical axis represents the short-circuit current ratio. Fig. 10 illustrates the relationship between the treatment time for the holding treatment step B, and the open-circuit voltage and fill factor of the produced solar cell module. In this figure, the horizontal axis represents the treatment time, the left vertical axis represents the open-circuit voltage ratio, and the right vertical axis represents the fill factor ratio. The definitions for the output ratio, the short-circuit current ratio, the open-circuit voltage ratio and the fill factor ratio are the same as those described for Fig. 7 and Fig. 8.
In the plots illustrated in Fig. 9 and Fig. 10, the average value for each of the evaluation items was calculated in one-hour intervals for the period from a treatment time of 0 hours to a treatment time of 10 hours, in two-hour intervals for the period from 10 hours to 20 hours, in four-hour intervals for the period from 20 hours to 40 hours, and in 10-hour intervals for the period from 40 hours to 60 hours.

As is evident from Fig. 9, the output ratio increased as the treatment time was lengthened. Fluctuation in the output ratio was considerable up until a treatment time of 20 hours, but the output ratio stabilized above 20 hours. The output ratio increased even further for treatment times of 40 hours or longer. For treatment times of 50 to 60 hours, the output ratio increased by an average of 2.4%. Almost no additional increase in the output ratio was observed when the treatment time was increased beyond 50 hours. Further, if the treatment time exceeds 50 hours (approximately two days), then the volume of the stocker required for holding the substrates having the layers prior to the second power generation cell layer 92 deposited thereon becomes overly large, and it was therefore determined that a treatment time longer than 50 hours did not yield an associated satisfactory improvement in the output ratio.
The rate of increase in the output ratio tended to reduce at a treatment time of 20 to 30 hours, but increases in the open-circuit voltage and the fill factor were observed up until a treatment time of 30 to 40 hours, with the open-circuit voltage ratio increasing by an average of 0.6% and the fill factor ratio increasing by an average of 1.0%. However, the short-circuit current showed almost no increase, even following a treatment time of 40 hours. In other words, in the holding treatment step B , the increases observed in the open-circuit voltage and the fill factor in the initial stages of the treatment contribute to an increase in the output.
On the other hand, when the treatment time was lengthened beyond 30 to 40 hours, although almost no change was observed in the open-circuit voltage and the fill factor, an increase in the short-circuit current was observed for treatment times of 40 hours or longer. The short-circuit current ratio increased an average of 0.8% for a treatment time of 50 to 60 hours.

Fig. 11 is a graph illustrating the change in optical properties when a simulated intermediate contact layer 5 prepared by forming a lone GZO film (amount of Ga doping: 0.5 wt%) on a glass substrate was held under the same conditions as the holding treatment step B. In the figure, the horizontal axis represents the treatment time, and the vertical axis represents the sum of the transmittance and the reflectance (the value obtained by subtracting the absorption from 100%, equivalent to the internal transmittance) at wavelengths of 600 nm, 700 nm and 800 nm.
From the results shown in Fig. 11 it is evident that the intermediate contact layer exhibits slight coloration due to oxygen deficiency immediately following deposition, but this oxygen deficiency starts to be restored after approximately 10 hours standing in an open atmosphere. As shown in Fig. 11, almost no change in the optical properties was observed once the holding time exceeded 50 hours.

Based on the results shown in Fig. 9 to Fig. 11, it is surmised that the reason the output improves as a result of implementing the holding treatment step B is because, in the initial stages of the treatment up to a treatment time of 40 hours, the exposure to the open atmosphere causes oxygen that exists within the atmosphere to adsorb by affinity to the oxygen atoms at the surface of the intermediate contact layer 5, thereby forming an oxygen adsorption layer. This oxygen adsorption layer improves the resistance of the intermediate contact layer to reduction caused by the hydrogen plasma during deposition of the p-layer 41 of the second power generation cell layer 92, and also makes the surface of the intermediate contact layer 5 a more uniform oxide film, which promotes more uniform growth of the p-layer 41 of the second power generation cell layer 92 during the initial stages of deposition, thus further improving the uniformity of the interface properties between the intermediate contact layer 5 and the p-layer 41. Moreover, it is thought that at treatment times of 40 hours or longer, oxygen supply into the interior of the intermediate contact layer 5 progresses, thus improving the transmittance of the intermediate contact layer 5 by eliminating oxygen deficiency, and increasing the amount of incident light entering the second power generation cell layer 92.
In order to form a more uniform oxygen adsorption layer on the surface of the intermediate contact layer 5, and achieve resupply of oxygen to the oxygen-deficient interior of the intermediate contact layer 5, a treatment step in which the substrate having the intermediate contact layer 5 formed thereon is held within an open atmosphere at room temperature for a prescribed period of time represents a reliable yet simple treatment method.

### (Example 3: Combination of Holding Treatment Step A and Holding Treatment Step B)

A solar cell module 6 having the stacked structure illustrated in Fig. 1 was formed on a glass substrate having dimensions of 1.4 m × 1.1 m. The thickness and deposition conditions for each of the layers were the same as those described for the example 1. In the example 3, both the holding treatment step A and the holding treatment step B were implemented under the conditions described above.

Fig. 12 illustrates the relationship between the output of the solar cell module and the treatment time for the holding treatment step B, wherein the treatment time for the holding treatment step A is classified as either 0 to 1 hour, or not less than 5 hours (but not more than 25 hours). In the figure, the horizontal axis represents the treatment time and the vertical axis represents the output ratio. The output ratio represents a value that is normalized against the average value for the output ratio when the treatment times for the holding treatment steps A and B are both from 0 to 1 hours.
Fig. 13 illustrates the relationship between the open-circuit voltage, the fill factor and the short-circuit current of the solar cell module, and the treatment time for the holding treatment step B, wherein the treatment time for the holding treatment step A is classified as either 0 to 1 hour, or not less than 5 hours (but not more than 25 hours). In the figure, the horizontal axis represents the treatment time, the left vertical axis represents the open-circuit voltage ratio and the fill factor ratio, and the right vertical axis represents the short-circuit current ratio. The open-circuit voltage ratio, the fill factor ratio, and the short-circuit current ratio each represents a value that is normalized against the average value when the treatment times for the holding treatment steps A and B are both from 0 to 1 hours.
In the plots illustrated in Fig. 12 and Fig. 13, the average value for each of the evaluation items was calculated in one-hour intervals for the period from a treatment time of 0 hours to a treatment time of 2 hours, in two-hour intervals for the period from 10 hours to 20 hours, and in four-hour intervals for the period from 20 hours to 36 hours. Further, the average value for each evaluation item was also calculated for the periods from 2 hours to 5 hours, from 5 hours to 10 hours, from 36 hours to 50 hours, and from 50 hours to 60 hours.

Reference to Fig. 12 reveals that the output ratio increased by an average of 2.8% when the holding treatment step A was not less than 5 hours and the holding treatment step B was from 50 to 60 hours. Of this increase, the portion contributed by the holding treatment step A (indicated by (2) in Fig. 12) was 0.8%, and the portion contributed by the holding treatment step B (indicated by (1) in Fig. 12) was 2.0%. Compared with the example 1 and the example 2, although the output improvement effect attributable to each of the holding treatment steps was approximately 20% to 50% less than the sum of the individual increases observed when each of the treatment steps was performed alone, the combination of the holding treatment step A and the holding treatment step B did yield a further improvement in performance. It is surmised that this observation is due to the fact that during mutual distribution of the incident light energy entering the solar cell module 6 between the first power generation cell layer 91 and the second power generation cell layer 92 for the purpose of power generation, the effect of the holding treatment step B will influence the size of the effect achieved from the holding treatment step A.

As illustrated in Fig. 13, a difference was observed in the short-circuit current ratio when the treatment time of the holding treatment step A was varied. The holding treatment step A had almost no effect on the open-circuit voltage ratio and the fill factor ratio, which tended to increase as the treatment time of the holding treatment step B was lengthened. These observations match the trends described above for the examples 1 and 2.
In order to form an extremely thin film of a natural oxide of silicon on the surface of the n-layer 33 of the first power generation cell layer 91, and also supply oxygen to the surface and the interior of the intermediate contact layer 5, treatment steps in which the substrate is held within an open atmosphere at room temperature for a prescribed period of time, both following formation of the first power generation cell layer 91 and following formation of the intermediate contact layer 5, represent a reliable yet simple treatment method.

The holding treatment step A and the holding treatment step B employed in the examples 1 to 3 are treatment steps in which the target substrate is held within an open atmosphere at room temperature for a prescribed period of time, but there is no necessity to restrict the temperature to a room temperature value within a prescribed range. If the control range of the room temperature varies, then the treatment time may be reset appropriately in accordance with the altered control range of the room temperature.
For example, by performing the treatment in a stocker that is maintained at a temperature slightly higher than room temperature under a hot air flow of 40°C to 50°C, the treatment time can be shortened.
In this case, selected tests may be performed to enable the atmospheric temperature and the treatment time to be set to appropriate values within the scope of the present invention.

### {Reference Signs List}

1 Substrate
2 Transparent electrode layer
3 Photovoltaic layer
4 Back electrode layer
5 Intermediate contact layer
6 Solar cell module
7 Power generation cell
31 Amorphous silicon p-layer
32 Amorphous silicon i-layer
33 Amorphous silicon n-layer
41 Crystalline silicon p-layer
42 Crystalline silicon i-layer
43 Crystalline silicon n-layer
50 Solar cell panel
91 First power generation cell layer
92 Second power generation cell layer
100 Photovoltaic device
103L, 103S Aluminum frame

## Claims

1. A process for producing a photovoltaic device, the process comprising the steps of forming a first power generation cell layer on a substrate, forming an intermediate contact layer on the first power generation cell layer, and forming a second power generation cell layer on the intermediate contact layer, wherein
the process comprises at least one of:
a step of holding the substrate in an open atmosphere at room temperature for not less than 5 hours and not more than 25 hours following formation of the first power generation cell layer, and
a step of holding the substrate in an open atmosphere at room temperature for not less than 20 hours and not more than 50 hours following formation of the intermediate contact layer.

2. The process for producing a photovoltaic device according to claim 1, wherein the process comprises at least one of:
a step of holding the substrate in an open atmosphere at room temperature for not less than 8 hours and not more than 20 hours following formation of the first power generation cell layer, and
a step of holding the substrate in an open atmosphere at room temperature for not less than 40 hours and not more than 50 hours following formation of the intermediate contact layer.

3. The process for producing a photovoltaic device according to claim 1 or claim 2, wherein the substrate is held inside a clean stocker of class 100,000 or less.
